Europäisches Patentamt

European Patent Office

Office européen des brevets

(19)

(11) **EP 0 788 663 B1**

(12) **EUROPÄISCHE PATENTSCHRIFT**

(45) Veröffentlichungstag und Bekanntmachung des Hinweises auf die Patenterteilung:
16.12.1998  Patentblatt 1998/51

(21) Anmeldenummer: 94905661.8

(22) Anmeldetag: 20.01.1994

(51) Int Cl.[6]: **H01L 39/22**

(86) Internationale Anmeldenummer:
PCT/EP94/00140

(87) Internationale Veröffentlichungsnummer:
WO 94/17561 (04.08.1994 Gazette 1994/18)

(54) **QUASITEILCHEN-INJEKTIONSTRANSISTOR**

QUASI PARTICLE INJECTION TRANSISTOR

TRANSISTOR A INJECTION DE QUASI-PARTICULES

(84) Benannte Vertragsstaaten:
CH DE FR GB IT LI

(30) Priorität: 20.01.1993  DE 4301439

(43) Veröffentlichungstag der Anmeldung:
13.08.1997  Patentblatt 1997/33

(73) Patentinhaber: Müller, Paul
D-80333 München (DE)

(72) Erfinder: Müller, Paul
D-80333 München (DE)

(74) Vertreter: Rost, Jürgen, Dipl.-Ing. et al
Patent- und Rechtsanwälte,
Bardehle . Pagenberg . Dost . Altenburg .
Geissler . Isenbruck
Postfach 86 06 20
81633 München (DE)

(56) Entgegenhaltungen:
EP-A- 0 350 547          EP-A- 0 491 496

• PATENT ABSTRACTS OF JAPAN vol. 017, no. 214 (E-1357)27. April 1993 & JP,A,04 352 373 (CENTRAL RES INST OF ELECTRIC POWER IND) 7. Dezember 1992
• PATENT ABSTRACTS OF JAPAN vol. 011, no. 187 (E-516)16. Juni 1987 & JP,A,62 015 869 (NIPPON TELEGR & TELEPH CORP ) 24. Januar 1987
• JOURNAL OF PHYSICS D: Applied Physics, Band 20, Nr. 10, 14. Oktober 1987, Seiten 1330 - 1335

## Beschreibung

Die Erfindung bezieht sich auf einen Quasiteilchen-Injektionstransistor, wie er aus der Literaturstelle Physica 126 B (1984), S. 165 - 175, S. M. Faris: "Quiteron" bekannt ist. EP-A-0 350 547 offenbart einen Quasiteilchen-Injektionstransistor nach dem ersten Teil des vorliegenden Anspruchs 1.

Bei dem bekannten Quasiteilchen-Injektionstransistor handelt es sich um ein supraleitendes Schaltelement mit drei Anschlüssen. Zwischen den drei Anschlüssen kann ein transistorähnliches Kennlinienfeld gemessen werden, wie weiter unten noch dargelegt wird. Das Kennlinienfeld läßt sich durch den physikalischen Effekt der Quasiteilchen-Injektion erklären. Nach Faris kann ein dünner supraleitender Film auf unterschiedliche Weise, insbesondere durch Quasiteilchen-Injektion, normalleitend oder resistiv werden. Bei diesem Vorgang werden die für die Supraleitung verantwortlichen Cooperpaare aufgebrochen. Dementsprechend erhöht sich in dem dünnen supraleitenden Film die Dichte der Quasiteilchen, d.h. die Dichte der Elektronen oder Löcher. die sich nach den Gesetzen des resistiven Ladungstransports durch den Festkörper bewegen. Zur Realisierung der Quasiteilchen-Injektion benutzt Faris einen Tunnelkontakt, den er Injektor nennt. Der Injektor-Tunnelkontakt besteht aus einem Supraleiter $S_1$, einer extrem dünnen Isolationsschicht als Tunnelbarriere und einem dünnen supraleitenden Film $S_2$. Die Kennlinie des Injektors zeigt bei Faris das typische Verhalten eines supraleitenden Tunnelkontakts. In einem ersten Gleichgewichtszustand kann ein Strom, der unterhalb einer kritischen Stromstärke liegt, ohne Spannungsabfall durch den supraleitenden Tunnelkontakt fließen. Überschreitet jedoch der Strom die kritische Stromstärke, so schaltet der Tunnelkontakt auf einen zweiten Gleichgewichtszustand um, der sich durch einen Spannungsabfall über dem Kontakt auszeichnet. Die zugehörige Kennlinie zeigt im unterkritischen Bereich einen resistiven und im unterkritischen Bereich einen stark nichtlinearen Verlauf.

Ein vollständiger Quasiteilchen-Injektionstransistor entsteht nach Faris dadurch, daß dem Injektor-Tunnelkontakt ein zweiter Tunnelkontakt, der Akzeptor, hinzugefügt wird. Der Injektor und der Akzeptor haben den dünnen supraleitenden Film $S_2$ gemeinsam, d.h. die gesamte Struktur besteht aus drei supraleitenden Schichten $S_1$, $S_2$, $S_3$, die durch zwei isolierende Tunnelbarrieren voneinander getrennt sind. Solange der Akzeptor durch den Injektor nicht beeinflußt wird, zeigt er die bekannte nichtlineare Strom-Spannungs-Kennlinie für den unterkritischen Gleichgewichtszustand, die zuvor bereits für den Injektor dargestellt wurde. Wenn jedoch der Injektor in den dünnen supraleitenden Film $S_2$ Quasiteilchen injiziert, dann verändert sich der Akzeptor von einem Supraleiter-Isolator-Supraleiterkontakt zu einem Normalleiter-Isolator-Supraleiterkontakt. Die zugehörige Kennlinie verschiebt sich zu kleineren Spannungen hin.

Die beiden Akzeptoranschlüsse können nach Faris mit einem linearen oder nichtlinearen Lastwiderstand verbunden werden. Der Injektionstransistor schaltet dann zwischen zwei stabilen Zuständen um, die binäre Zustände 0 und 1 repräsentieren können. Die Lastkurve schneidet die Supraleiter-Isolator-Supraleiterkennlinie bei einer ersten Spannung, bei der keine Injektion herrscht, und sie schneidet die Normalleiter-Isolator-Supraleiterkennlinie bei einer zweiten Spannung, die einer überkritischen Injektion entspricht. Faris konnte zeigen, daß sich diese binären Signale für eine Kettenschaltung von Quasiteilchen-Injektionstransistoren eignen.

Weitere Einzelheiten sind der genannten Literaturstelle zu entnehmen, auf die sich die Erfindung vollständig bezieht, auch wenn Einzelheiten nicht ausdrücklich zitiert sind.

Schaltkreiselemente mit drei Anschlüssen, zu denen der Quasiteilchen-Injektionstransistor von Faris gehört, haben für logische Schaltkreise aller Art prinzipielle Vorteile gegenüber Schaltkreiselementen mit nur zwei Anschlüssen (vgl. Reviews of Modern Physics, Band 61, Heft 2, April 1989, S. 279 - 287, R. W. Keyes: "Physics of Digital Devices"). Wie Keyes zeigt, werden einige wesentliche Voraussetzungen für die Höchstintegration von digitalen Schaltkreisen durch Schalttransistoren wesentlich besser erfüllt als durch Schaltdioden. Zu diesen Voraussetzungen gehören eine hohe Verstärkung, eine ausgeprägte Nichtlinearität der Kennlinie, eine sehr geringe Rückwirkung des Ausgangs auf den Eingang, eine geringe Empfindlichkeit gegenüber Parameterschwankungen des Signals, des Materials und der Umgebung, eine hohe Packungsdichte, ein geringer Leistungsverlust und eine Inversion des binären Ausgangssignals gegenüber dem binären Eingangssignal. Schaltelemente mit zwei Anschlüssen, zu denen beispielsweise der Josephsonkontakt gehört, können solche Ansprüche nicht hinreichend erfüllen. Zwar ist das abrupte Auftreten der Spannung am Josephsonkontakt der schnellste und dissipationsärmste Schaltvorgang, welcher derzeit bekannt ist; jedoch fehlt es an der erwähnten Verstärkung, der Inversion (gemeint ist die logische Negation) und der Rückwirkungsfreiheit zwischen Eingangssignal und Ausgangssignal (vgl. Keyes aaO.). Bistabile Schaltelemente mit zwei Anschlüssen benötigen außerdem ein separates Rücksetzen und können nur wenige nachfolgende Schaltelemente gleicher Bauart ansteuern.

Es besteht somit ein starkes Bedürfnis nach supraleitenden Schaltelementen mit drei Anschlüssen. Der Vorschlag von Faris hat aus Gründen, die anschließend erörtert werden und die für das Verständnis der Erfindung wichtig sind, keine breite Anwendung gefunden. Das Fehlen praktikabler Drei-Anschluß-Schaltelemente ist einer der größten Hinderungsgründe für eine breite technische Anwendung der Elektronik mit supraleitenden Materialien. Insbesondere werden strom- oder leistungsverstärkende Eigenschaften der Schaltelemente benötigt, um die Verluste auszugleichen, die bei schnellen Schaltvorgängen auftreten. Da man mit rein supraleitenden Elementen keine Strom- oder Leistungsverstärkung erreichen kann, greift die Erfindung insoweit auf den Vorschlag von Faris zurück, als der Tunnelprozeß im resistiven Zustand, d.h. oberhalb des kritischen Stroms, in einem Doppel-Tunnelkontakt genutzt wird. Das gemeinsame Prinzip besteht in einem Tunnelkontakt (Injektor), der bei genügend hoher Stromdichte so viele Ladungsträger in eine Elektrode eines zweiten Tunnelkontakts (Akzeptor) injizieren kann, daß dessen supraleitende Energielücke merklich abnimmt.

Faris hat gezeigt, daß ein solches Schaltelement eine hohe Verstärkung aufweist. Weitere Vorteile für die Anwendung in der Digitaltechnik sind seine hohe Schaltgeschwindigkeit und die Invertierung des Signals beim Schaltvorgang. Faris beschreibt mehrere detaillierte Ausführungen zur Verbesserung der Eigenschaften des bekannten Quasiteilchen-Injektionstransistors. Allen diesen Ausführungsformen ist gemeinsam, daß sie schichtweise aus klassischen Supraleitern mit Tunnelbarrieren aufgebaut sind. Der bekannte Quasiteilchen-Injektionstransistor wird auf einem Siliziumsubstrat hergestellt. Die Tunnelkontakte haben Abmessungen zwischen 2,5 und 7,5 μm Für die Supraleiter $S_1$ und $S_2$ wird Niob verwendet, für den Supraleiter $S_3$ eine Blei-Indium-Gold-Legierung. Die erste Niobschicht $S_1$ ist 2000 Å dick und wird durch chemisches Ätzen strukturiert (10Å = 1 nm). Die Tunnelbarriere des Injektors entsteht durch eine Oxidationstechnik und ist 20 - 40 Å dick. Danach wird die 300 Å dicke Niobschicht $S_2$ deponiert. Nach dem Oxidieren der Tunnelbarriere des Akzeptors wird die Gegenelektrode $S_3$, bestehend aus einer 5000 Å dicken Blei-Indium-Gold-Schicht deponiert. Zwischen diesen Herstellungsschritten sind weitere Prozeßschritte erforderlich, die der Herstellung von Anschlußkontakten und der Flächenfestlegung des Bauelements durch isolierende Nioboxid- und Siliziumoxidschichten dienen. Es kommen verschiedene geometrische Konfigurationen in Frage, z.B. Randtunnelkontakte oder planare Tunnelkontakte.

Die bekannte Materialtechnologie stößt auf Schwierigkeiten, die sich bereits in der Veröffentlichung von Faris widerspiegeln. Die Literaturstelle spricht von der Notwendigkeit, die ingenieurmäßigen Anforderungen zu erfüllen. Zur Realisierung ist eine zwecktnäßige Auswahl bei folgenden Parametern erforderlich: supraleitende Materialien, Filmdicken, Tunnelparameter, geometrische Konfigurationen und andere einschlägige Parameter. Die Tunnelkontakte bezeichnet Faris als rauh, weil Niob benutzt wird.

Auch mit heutigen Herstellungsmethoden und optimierten Materialien sind solche vertikal gestapelten Sandwich-Tunnelkontakte nur sehr aufwendig herzustellen (vgl. Applied Superconductivity Conference, Chicago 1992, H. Kohlstedt et aL: "Preparation and Properties of Nb / Al-AlO$_x$ / Nb Multilayers"). Dabei bereitet die akkumulierte mechanische Spannung in den Nb-Filmen Probleme. Die Al- und Nb-Filme sind polykristallin und haben Korngrößen von 10 - 40 nm. Die reale Kristallstruktur ist von der idealen, bei der alle Tunnelbarrieren identisch sein müßten, weit entfernt. Bei dem Versuch, die mechanische Spannung in den Nb-Filmen zu lindern, können die Ränder des Tunnelkontakts beschädigt werden, so daß der Leckstrom des Tunnelkontakts ansteigt. Bei einer zehnfachen Anordnung von Tunnelkontakten nimmt die Gleichmäßigkeit der kritischen Josephsonströme im Vergleich zu einer dreifachen Anordnung bereits merklich ab. Demnach sind Mehrfach-Tunnelkontakte aus klassischen Supraleitern umso schwerer herzustellen, je größer die Zahl der übereinander aufgebrachten Schichten wird.

Derselben Schwierigkeit sieht man sich in noch stärkerem Maße bei Hochtemperatur-Supraleitern gegenüber. Um Josephsonkontakte aus keramischen Supraleitern herzustellen, nutzt man als Schwachstelle eine Korngrenze zwischen aneinanderstoßenden Kristallen. Aus der Literaturstelle Superconductor Industry, Band 4, Heft 2, Sommer 1991, S. 31 - 32, geht hervor, daß Korngrenzenkontakte dieser Art nicht so leistungsfähig sind wie Josephsonkontakte, die aus klassischen Niedertemperatur-Supraleitern aufgebaut sind. Zur Erzeugung der dünnen Filme der Korngrenzenkontakte werden Verfahren der Laserablagerung und der Photolithographie herangezogen. Bei der Laserablagerung beispielsweise wachsen drei Schichten nacheinander epitaxial auf einem Substrat auf. Zwei Hauptprobleme dieser Korngrenzenkontakte werden benannt. Der genaue Ort, an dem der Kontakt zwischen den supraleitfähigen und den nicht supraleitfähigen Schichten auftritt, unterliegt dem Zufall und ist kaum steuerbar. Außerdem ist die Erzeugung einer größeren Zahl von Kontakten noch nicht steuerbar. Überdies ist davon auszugehen, daß diese Kontakte keine reinen Supraleiter-Isolator-Supraleiter-Tunnelkontakte sind. Wegen dieser technologischen Schwierigkeiten ist bisher noch kein Versuch bekannt geworden, einen Quasiteilchen-Injektionstransistor oder ein anderes Schaltelement mit drei Anschlüssen aus Hochtemperatur-Supraleitern aufzubauen.

Die Erfindung sieht sich deshalb vor der Aufgabe, Quasiteilchen-Injektionstransistoren einfacher herzustellen, als dies mit bekannten Strukturierungsverfahren möglich ist.

Die Lösung dieser Aufgabe besteht gemäß dem Patentanspruch 1 darin, daß der Injektor und jeder Akzeptor des Quasiteilchen-Injektionstransistors ein Hochtemperatur-Supraleiter ist, der jeweils aus einem kristallinen Stapel vieler intrinsischer Tunnelkontakte besteht Ein Verfahren zur Herstellung dieses intrinsischen Quasiteilchen-Injektionstransistors ist im Patentanspruch 17 angegeben. Zweckmäßige Weiterbildungen gehen aus den Unteransprüchen hervor.

Die Erfindung beruht auf der Erkenntnis, daß bei bestimmten Hochtemperatur-Supraleitern die Relation zwischen dem Schichtabstand der supraleitfähigen Ebenen oder Doppelebenen (im folgenden auch Schichten oder Doppelschichten genannt) und der Ginzburg-Landau-Kohärenzlänge der entscheidende Materialparameter zur Bildung intrinsischer Tunnelkontakte ist. Innerhalb eines Kristalls bilden eine Vielzahl intrinsischer Tunnelkontakte einen Stapel von atomarer Größenordnung, und solche Stapel können zu Injektorstapeln und Akzeptorstapeln zusammengesetzt werden, um Quasiteilchen-Injektionstransistoren zu bilden.

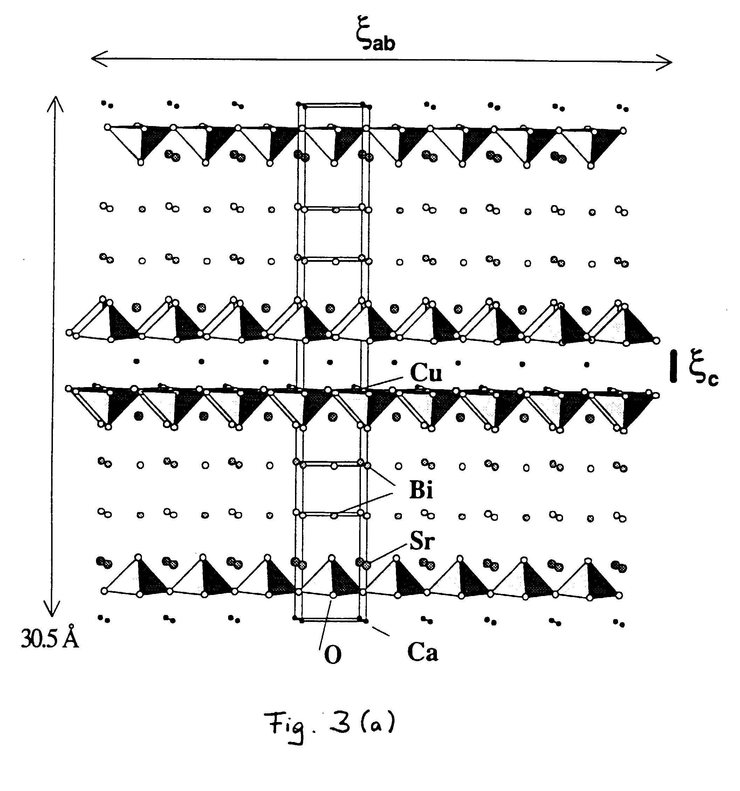

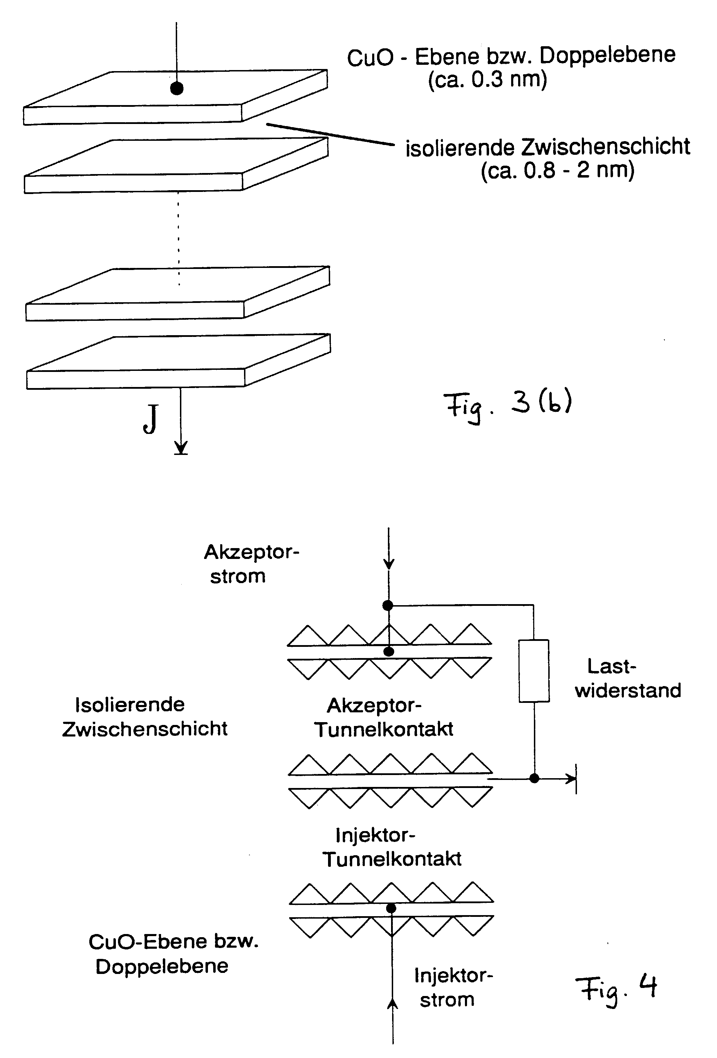

Bei der Erfindung wird eine Besonderheit der Kristallstruktur der Hochtemperatur-Supraleiter benutzt, um Tunnelkontakte und daraus Quasiteilchen-Injektionstransistoren zu konstruieren. Die Hochtemperatur-Supraleiter sind kristalline Schichtstrukturen, bei denen der elektrische Transport in $CuO_2$-Ebenen stattfindet. Die elektrische Leitfähigkeit in Richtungen parallel zu den $CuO_2$-Ebenen kann um mehrere Größenordnungen oberhalb der Leitfähigkeit senkrecht dazu (Leitfähigkeit in Richtung der c-Achse) liegen. Diese Anisotropie ist in Fig. 3a und Fig. 3b am Beispiel des Hochtemperatur-Supraleiters $Bi_2Sr_2CaCu_2O_8$ dargestellt. Er besitzt eine Sprungtemperatur von beispielsweise 80 - 90 K. Man erkennt Doppelebenen aus $CuO_2$, in denen die Koordinationspolyeder jeweils von Pyramiden gebildet werden. Zwischen $CuO_2$-Ebenen liegen Schichten mit Bi-, Sr- und Ca-Atomen. In den Schichten zwischen den einzelnen $CuO_2$-Doppelebenen läßt sich außerdem eine bestimmte Menge von Sauerstoffatomen unterbringen.

Für die Erfindung kommen zwei Klassen von Hochtemperatur-Supraleitern in Frage. Die erste Klasse weist Doppelebenen von $CuO_2$ auf, wie sie in Fig. 3a dargestellt sind. Jede Doppelebene ist ein supraleitendes Gebiet mit hoher Cooperpaardichte. Zwischen den Doppelebenen befinden sich jeweils Tunnelkontakte. Beispiele für Hochtemperatur-Supraleiter dieser Klasse sind:

$$(Bi_{1-x}Pb_x)_2Sr_2CaCu_2O_8 \qquad 0 \leq x < 0,4$$

$$(Bi_{1-x}Pb_x)_2Sr_2Ca_2Cu_3O_{10} \qquad 0 \leq x < 0,4$$

$$Tl_2Ba_2CaCu_2O_8$$

$$Tl_2Ba_2Ca_2Cu_3O_{10}$$

$$TlCaBa_2Cu_2O_7$$

$$TlCaBa_2CuO_9.$$

Ein Beispiel für eine zweite Klasse von Hochtemperatur-Supraleitern, in denen das $CuO_2$ in einfachen Ebenen statt in Doppelebenen vorliegt, ist $TlBa_2CuO_5$. Die Koordination von Kupfer und Sauerstoff in diesen Ebenen geschieht in Oktaedern. Auch zwischen je zwei solchen Ebenen können mit der erfindungsgemäßen Technik Tunnelkontakte gebildet werden, so daß entsprechende Injektorstapel und Akzeptorstapel zu Quasiteilchen-Injektionstransistoren zusammengesetzt werden können.

Bisherige Realisierungen von Tunnelkontakten und Quasiteilchen-Injektionstransistoren zielten darauf ab, extrinsische Grenzschichten zwischen Supraleitern nutzbar zu machen. Die Eigenschaften dieser Grenzschichten waren im Stand der Technik für die Schwachstelle zwischen den supraleitenden Gebieten verantwortlich. Dieser Ansatz erforderte einen erheblichen Aufwand bei der Herstellung des Kontakts. Trotz des hohen Aufwands sind Tunnelkontakte und Quasiteilchen-Injektionstransistoren dieser Art schlecht reproduzierbar.

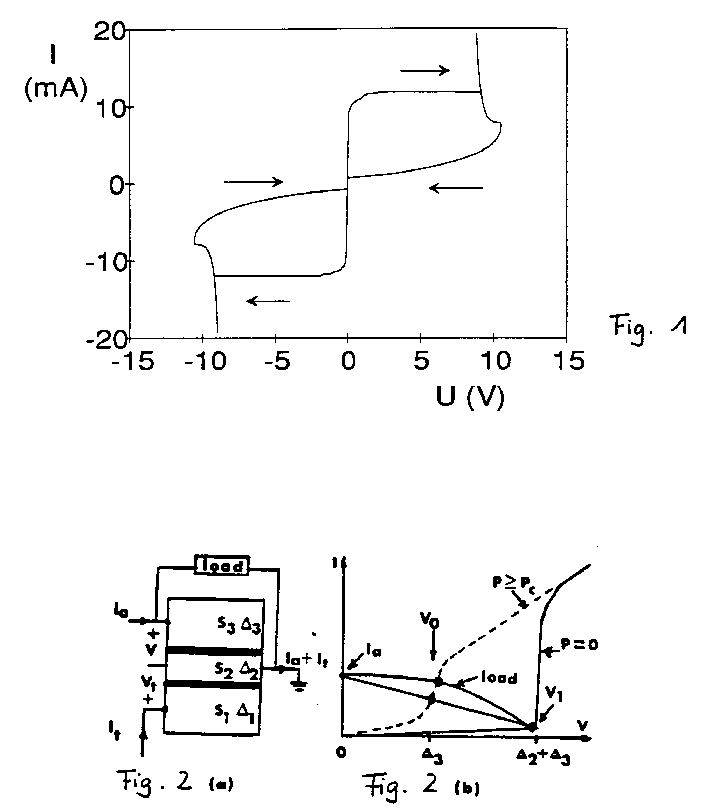

Nach der Lehre der älteren Anmeldung EP-A-0 523 725, die unter Art. 54(3) EPÜ fällt, können sogenannte intrinsische Josephsonkontakte hergestellt werden. Aus geeigneten Metalloxiden können Kristalle hergestellt und einer $O_2$-Behandlung unterzogen werden. Nach dem Abkühlen eines solchen Kristalls auf beispielsweise 80 K werden die $CuO_2$-Ebenen oder -Doppelebenen supraleitend. Die metalloddischen Zwischenschichten vermitteln gemäß der älteren Anmeldung EP-A-0 523 725 eine Kopplung, die zu einer intrinsischen Ausbildung der Josephsoneffekte führt. Die Kopplungsschichten können supraleitende, leitende oder isolierende Eigenschaften haben. Im Unterschied hierzu ist es für die vorliegende Erfindung wichtig, daß die Kopplungsschichten vornehmlich isolierende Eigenschaften haben, so daß der Übergang der Cooperpaare von einer supraleitenden $CuO_2$-Schicht zu einer anderen supraleitenden $CuO_2$-Schicht in Form des quantenmechanischen Tunneleffekts stattfindet. Jede der erfindungsgemäßen Strukturen "Supraleiter-Isolator-Supraleiter" hat daher die Kennlinie eines Tunnelkontakts. Da viele übereinanderliegende Tunnelkontakte wegen ihrer gleichmäßigen Kopplung gleichzeitig schalten, wirkt die ganze Kristallschichtstruktur elektronisch gesehen wie eine einzige Tunneldiode mit hohem Spannungsabfall (vgl. Fig. 1). Ebenso ist es für das Prinzip eines Injektor-Akzeptor-Stapels wichtig, daß die Zwischenschichten gut isolierend sind, wie aus der elementaren Struktur eines intrinsischen QuasiteilchenInjektionstransistors "Supraleiter-Isolator-Supraleiter-Isolator-Supraleiter" gemäß Fig. 4 zu ersehen ist. Im Unterschied zu den Mikrowellenanwendungen gemäß der älteren Anmeldung EP-A-0 523 725, bei denen die Resonanzen des AC-Josephsoneffekts durch kleine Kapazitäten pro Flächeneinheit im Ersatzschaltbild begünstigt wurden, sind für die hier beanspruchte Anwendung als Schaltelemente größere Kapazitäten pro Flächeneinheit wünschenswert. Diese Kapazitäten werden an den Injektionsvorgang angepaßt, wobei sowohl die Selbstinjektion von Quasiteilchen innerhalb eines Tunnelkontaktstapels als auch die Fremdinjektion aus einem Injektorstapel in einen Akzeptorstapel zu berücksichtigen sind. Die Kristalle gemäß der vorliegenden Erfindung werden deshalb im Hinblick auf eine möglichst ausgeprägte Hysterese der Strom-Spannungs-Kennlinie und im Hinblick auf einen möglichst ausgeprägten Tunneleffekt gezüchtet. Ein weiteres Kriterium ist eine möglichst hohe Stromdichte innerhalb des Hochtemperatur-Supraleiters.

Die Erfindung weist gegenüber bekannten Quasiteilchen-Injektionstransistoren und auch gegenüber bekannten Tunnelkontakten eine Reihe von Vorteilen auf. Die erfindungsgemäßen Schaltelemente können mit hohen Spannungen sogar im Voltbereich arbeiten, kommen wegen der dünnen Elektrodenschichten mit kleinen Schaltströmen aus, weisen extrem kurze Schaltzeiten auf, entkoppeln die Eingangsimpedanz ideal von der Ausgangsimpedanz, erlauben wegen ihrer extrem kleinen Abmessungen eine hohe Packungsdichte und lassen sich in ihren relevanten Eigenschaften (z.B. der Dikke des Kristalls) durch leicht einstellbare Prozeßparameter steuern. Diese Vorteile werden anhand der folgenden Ausführungsbeispiele dargestellt.

Es zeigt

Fig. 1     eine Strom-Spannungskennlinie in einem erfindungsgemäßen Hochtemperatur-Supraleiter, aus der die nutzbare Quasiteilchen-Injektion und die nutzbare Hysterese zu entnehmen sind;

Fig. 2a     den prinzipiellen Aufbau eines Quasiteilchen-Injektionstransistors, bestehend aus zwei Tunnelkontakten, die als Injektor und Akzeptor zusammengesetzt sind (diesen prinzipiellen Aufbau hat die Erfindung mit dem Stand der Technik Faris gemeinsam);

Fig. 2b     zwei Strom-Spannungs-Kennlinien eines Quasiteilchen-Injektionstransistors nach Fig. 2a, wobei die durchgezogene Kennlinie für einen Akzeptor ohne Quasiteilchen-Injektion und die gestrichelte Kennlinie für einen Akzeptor mit Quasiteilchen-Injektion gilt (dieses prinzipielle Verhalten teilt die Erfindung mit dem Stand der Technik Faris);

Fig. 3a     die Kristallstruktur eines erfindungsgemäß verwendeten Hochtemperatur-Supraleiters;

Fig. 3b     ein Modell des Stromtransports längs der kristallographischen c-Achse eines Hochtemperatur-Supraleiters;

Fig. 4     das Prinzip eines erfindungsgemäßen intrinsischen Quasiteilchen-Injektionstransistors mit einem Injektor und einem Akzeptor;

Fig. 5a     eine Realisierung des intrinsischen Quasiteilchen-Injektionstransistors, bei dem die Tunnelkontakte des Akzeptorstapels eine höhere Stromdichte aufweisen als die Tunnelkontakte des Injektorstapels;

Fig. 5b     eine Realisierung des intrinsischen Quasiteilchen-Injektionstransistors, bei der der Akzeptorstapel mehr Tunnelkontakte aufweist als der Injektorstapel;

Fig. 6     eine Realisierung des intrinsischen Quasiteilchen-Injektionstransistors, bei der zwei Akzeptoren eine Doppelstapelanordnung bilden; und

Fig. 7     eine mögliche Anordnung zweier Quasiteilchen-Injektionstransistoren zu zwei miteinander verbundenen Schaltelementen, wobei das Ausgangssignal des ersten Schaltelements zur Ansteuerung des zweiten Schaltelements verwendet wird.

Mit der Erfindung gelingt es durch gezielte Veränderung der Ginzburg-Landau-Kohärenzlänge senkrecht zu den $CuO_2$-Ebenen eines Hochtemperatur-Supraleiters, zwischen je zwei solcher Ebenen oder Doppelebenen Tunnelkontakte entstehen zu lassen und aus dieser Schichtstruktur Quasiteilchen-Injektionstransistoren zu konfigurieren. Zur Beeinflussung der Kohärenzlänge werden die Kristalle in Inertgasatmosphäre oder im Vakuum bei kontrolliertem $O_2$-Partialdruck und bei Temperaturen bis zu 700 °C getempert, bis ein Verhältnis der elektrischen Leitfähigkeit parallel zu den $CuO_2$-Ebenen zu der Leitfähigkeit senkrecht zu den Ebenen zwischen 10 und ca. $10^6$ erreicht ist. Die elektrischen Eigenschaften der Kontakte wie die Kapazität C und der Nebenschlußwiderstand R und die kritische Suprastromdichte $I_c$ lassen sich so für den gewünschten Anwendungsfall genau einstellen.

Außer dem Tempern des Hochtemperatur-Supraleiters bei kontrolliertem $O_2$-Partialdruck hat sich auch das Legieren von bestimmten chemischen Elementen als geeigneter Parameter zur Einstellung der intrinsischen Tunnelkontakte erwiesen. Als Legierungsmaßnahme kommt insbesondere eine Substitution von Bi durch Pb in Bi-Systemen in Frage. Auch eine ausgeprägte Abstufung der stöchiometrisch passenden Ca-Zugabe in Tl-Systemen ist hier zu nennen; diese Abstufung kann bis zum völligen Fehlen von Ca reichen. Außerdem kann in allen Systemen eine Interkalation von Jod, Brom oder anderen großen Atomen vorgesehen sein.

Die sogenannte Metall-(I)-Komponente der bevorzugten Hochtemperatur-Supraleiter kann aus Elementen der 3., 4. oder 5. Hauptgruppe oder Nebengruppe bestehen.

Es werden zwei oder mehr kleine Einkristalle nacheinander aus der Schmelze eines Hochtemperatur-Supraleiters gezogen, epitaktisch auf ein Substrat aufgebracht oder durch Strukturieren einer epitaktischen Schicht erzeugt. Die kleinen Einkristalle liegen so aneinander, daß sie eine Grenzfläche parallel zu den supraleitfähigen Schichten gemeinsam haben. Jeder Einkristall bildet einen Stapel von Tunnelkontakten in atomarer Größenordnung. Weil die Eigenschaften des Stapels auf die Schichtung des Einkristalls zurückzuführen sind, wird die Erfindung als Herstellung intrinsischer Tunnelkontakte und intrinsischer Quasiteilchen-Injektionstransistoren charakterisiert. Die $O_2$-Behandlung läuft im allgemeinen auf eine Verminderung der quantenmechanischen Kopplung zwischen den supraleitenden Ebenen hinaus, kann jedoch bei bestimmten Kristallen auch eine Erhöhung der quantenmechanischen Kopplung bewirken.

An den Grenzflächen, die parallel zu den supraleitfähigen Schichten der kleinen Einkristalle liegen, werden gut leitfähige Kontakte aufgedampft, Zur Herstellung von Quasiteilchen-Injektionstransistoren sind drei oder mehr solcher Kontakte vorgesehen.

Fig. 1 zeigt die Strom-Spannungs-Kennlinie eines Stapels von intrinsischen Tunnelkontakten, der sich als Akzeptorstapel eines Quasiteilchen-Injektionstransistors eignet. Die Kennlinie zeigt eine Hysterese mit einem kritischen Suprastrom $I_c$ von etwa 12 mA und einem Spannungsabfall von etwa 10 V. Der überkritische Ast der Kennlinie beruht zum Teil auf Quasiteilchen-Injektion; allerdings findet in diesem gemessenen Beispiel keine Injektion mittels des Injektors statt, sondern bei höheren Stromdichten kann Selbstinjektion innerhalb des Stapels von intrinsischen Tunnelkontakten auftreten, wie das Auftreten des negativen differentiellen Widerstands deutlich zeigt.

Die Figuren 2a und 2b zeigen das Prinzip der Quasiteilchen-Injektion von außen. Von dem Injektor-Tunnelkontakt $S_1$, $S_2$ gelangen Quasiteilchen in den Akzeptor-Tunnelkontakt $S_2$, $S_3$. Dadurch verschiebt sich die stark nichtlineare Kennlinie des Akzeptor-Tunnelkontakts zu einer mehr resistiven Kennlinie. Durch Beschaltung des Akzeptors mit einem linearen oder nichtlinearen Lastwiderstand ergeben sich zwei stabile Punkte im Kennlinienfeld, zwischen denen mit Hilfe des Injektorstroms umgeschaltet werden kann.

Die Größen in den Fig. 2a und 2b bedeuten nach Faris:

Ia Akzeptorstrom, $I_t$ Tunnelstrom, V Ausgangslastspannung, $V_t$ Tunnelspannung, $V_0$ Spannungsabfall im resistiven Zustand, $V_1$ Spannungsabfall im supraleitenden Zustand, $S_1$ Supraleiter 1, $S_2$ Supraleiter 2, $S_3$ Supraleiter 3, $\Delta_1$ Energielücke des ersten Supraleiters, $\Delta_2$ Energielücke des zweiten Supraleiters, $\Delta_3$ Energielücke

des dritten Supraleiters, P Leistungsdichte, $P_c$ kritische Leistungsdichte.

Um einen solchen Quasiteilchen-Injektionstransistor zu erzeugen, wird erfindungsgemäß die Schichtstruktur eines keramischen Materials herangezogen. In Fig. 3a ist beispielhaft die Kristallstruktur des Hochtemperatur-Supraleiters $Bi_2Sr_2CaCu_2O_8$ dargestellt. Die Kristallstruktur dieses an sich bekannten Hochtemperatur-Supraleiters zeichnet sich durch $CuO_2$-Doppelebenen aus. In einer Doppelebene stehen sich die Basisflächen von pyramidenförmigen Koordinationspolyedern gegenüber. An der Bildung der $CuO_2$-Doppelebenen ist eine Schicht von Ca-Atomen beteiligt. An der Außenseite der $CuO_2$-Doppelebenen sind Sr-Atome zu finden. Zwischen den $CuO_2$-Doppelebenen liegen verhältnismäßig dicke, wenig leitfähige Schichten aus Wismut und Sauerstoff. Die Bi-Atome können zur Änderung der Isolationseigenschaft durch Pb-Atome ersetzt werden. Durch kontrollierte $O_2$-Zugabe während der Herstellung oder Nachbehandlung kann die Leitfähigkeit der Zwischenschichten besonders gut gesteuert werden. Durch diese gezielte Veränderung der Leitfähigkeit senkrecht zu den Ebenen kann die Kopplung zwischen den Ebenen soweit vermindert werden, daß zwischen je zwei Ebenen oder Doppelebenen ein Tunnelkontakt entsteht. Ein so behandeltes Stück eines Hochtemperatur-Supraleiter-Einkristalls kann dann als Stapel von Tunnelkontakten angesehen werden. Diese Eigenschaft wird durch das Modell gemäß Fig. 3b beschrieben. Der Strom I wird längs der kristallographischen c-Achse durch alle Schichten des Hochtemperatur-Supraleiters transportiert. Bei der praktischen Realisierung der Erfindung konnte die Leitfähigkeit der Zwischenschichten soweit reduziert werden, daß eine Kette von nahezu idealen Tunnelkontakten entstand. Durch geeignete Temperprozesse in verschiedenen Gasatmosphären konnte weiterhin erreicht werden, daß im resistiven Zustand der Kontakte sogenannte Selbstinjektion, d.h. eine Verminderung der Energielücke in den einzelnen $CuO_2$-Ebenen durch einen genügend hohen Transportstrom I zu beobachten war. Dadurch ist die Voraussetzung zum Bau von intrinsischen Quasiteilchen-Injektionstransistoren erfüllt.

Die Fig. 4 zeigt das Prinzip eines Quasiteilchen-Injektionstransistors mit intrinsischen Tunnelkontakten. In der elementaren Anordnung bilden drei $CuO_2$-Schichten und zwei isolierende Zwischenschichten einen Injektor-Tunnelkontakt und einen Akzeptor-Tunnelkontakt. Die von den supraleitenden Kohärenzlängen und den Schichtabständen her erforderlichen Mindestabmessungen sind 3 nm x 3 nm x 3 nm. Eine solche Zelle würde nur noch ca. 1500 Atome enthalten. Diese theoretisch mögliche Miniaturisierung ist jedoch mit heutigen Methoden noch nicht realisierbar. Derzeit sind in der Ebene senkrecht zu der kristallographischen c-Achse Zellenabmessungen von 100 - 1000 nm machbar.

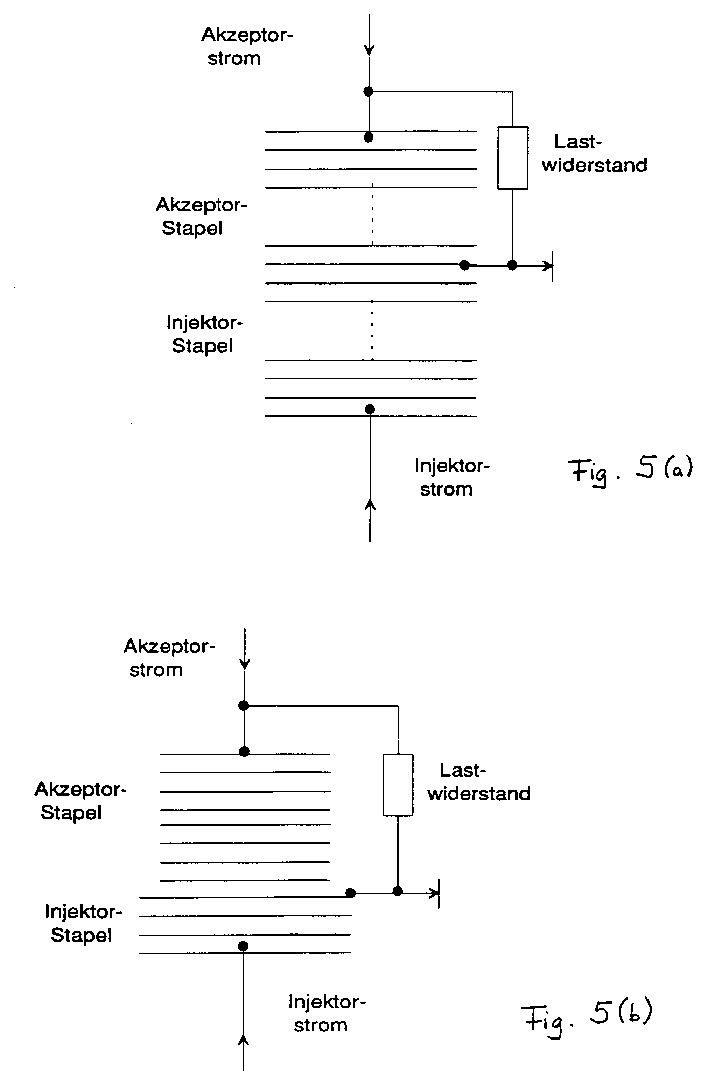

Die Fig. 5a und 5b zeigen zwei Realisierungen des Prinzips unter Verwendung ganzer Stapel von $CuO_2$-

Schichten anstelle der Einzelkontakte. Wegen der nur ca. 3 nm dicken Elektroden erstreckt sich die Injektion über viele Nachbarkontakte. Der wesentliche Vorteil dieser Stapelanordnung ist der damit erreichbare hohe Spannungsabfall. Es konnten Potentiale bis zu 10 V realisiert werden (vgl. Fig. 1).

Auch die Leistungsverstärkung des Schaltelements läßt sich in ähnlich einfacher Weise einstellen. In dem Ausführungsbeispiel gemäß Fig. 5a besteht der Injektorstapel aus dem Material gemäß Fig. 3, während in dem Akzeptorstapel eine gewisse Menge der Bi-Atome durch Pb-Atome substituiert ist. In diesem Fall richtet sich die Leistungsverstärkung G analog zu Faris nach dem Verhältnis der Stromdichten ($I_{ak}$, $I_{in}$) im Akzeptor und im Injektor. Durch die Legierung mit Pb erhöht sich die Stromdichte $I_{ak}$ im Akzeptorstapel und damit die Leistungsverstärkung. Im Unterschied zu Faris geht zusätzlich die Anzahl der Tunnelkontakte ($N_{ak}$, $N_{in}$) im Akzeptorstapel und im Injektorstapel in die Formel für die Leistungsverstärkung G ein:

$$G=\frac{P_{ak}}{P_{in}}=\gamma\cdot\frac{I_{ak}\cdot V_1\cdot N_{ak}}{I_{in}\cdot V_{in}^c\cdot N_{in}}.$$

Die einzelnen Größen bedeuten nach Faris:
G Leistungsverstärkung, $P_{ak}$ Leistungsdichte im Akzeptor, $P_{in}$ Leistungsdichte im Injektor, $\gamma$ Verlustfaktor für die Vorspannung, $I_{ak}$ Stromdichte im Akzeptor, $I_{in}$ Stromdichte im Injektor, $V_1$ Spannungsabfall im supraleitenden Zustand, $V_{inc}$ Spannungsabfall bei Quasiteilcheninjektion, ergänzt durch $N_{ak}$ Anzahl der Tunnelkontakte im Akzeptorstapel und $N_{in}$ Anzahl der Tunnelkontakte im Injektorstapel.

In dem Ausführungsbeispiel gemäß Fig. 5b ist die erforderliche Verstärkung durch eine erhöhte Anzahl von Tunnelkontakten im Akzeptorstapel realisiert. Die Stromdichten lassen sich außerdem durch Tempern in Gasatmosphäre einstellen.

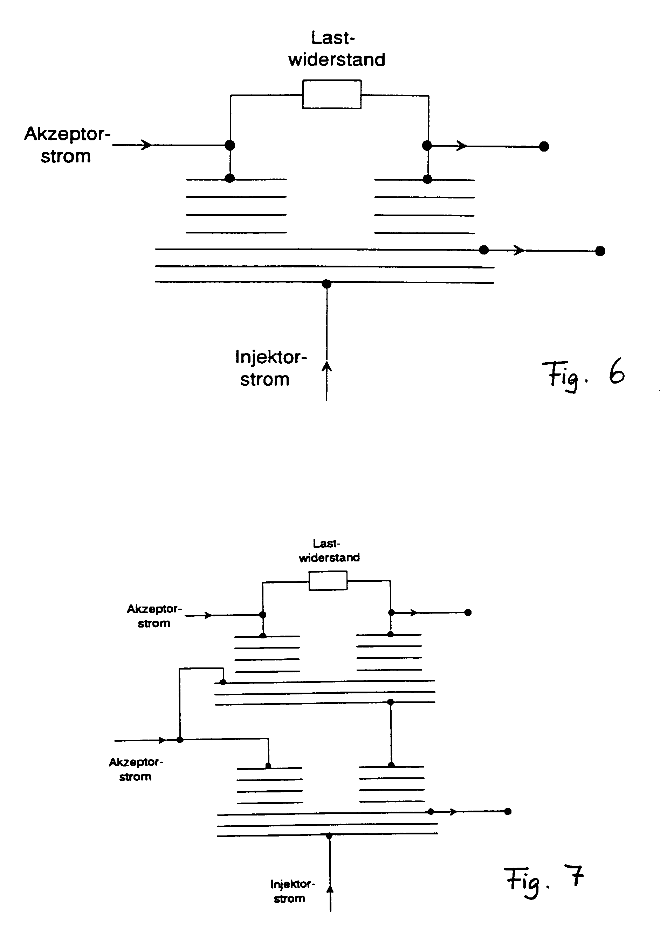

Die Fig. 6 zeigt ein Ausführungsbeispiel mit einer Doppelstapelanordnung von Akzeptoren. Durch diese Maßnahme läßt sich der Innenwiderstand des Akzeptorkreises an den Lastwiderstand anpassen. Vor allem erreicht man mit der Doppelstapelanordnung eine weitgehende Entkopplung zwischen Eingang und Ausgang. In diesem Fall verfügt das Schaltelement über vier Anschlüsse, also zwei Eingangsanschlüsse und zwei Ausgangsanschlüsse.

Eine wesentliche Verbesserung besteht darin, daß die intrinsischen Quasiteilchen-Injektionstransistoren wegen der dünnen Elektrodenschichten in den Tunnelkontakten nur geringe Schaltströme erfordern. Im Unterschied dazu weisen die bekannten Quasiteilchen-Injektionstransistoren relativ dicke Elektrodenschichten oberhalb von 10 nm auf, welche durch die für ihre Herstellung typischen Abscheideprozesse bedingt sind. Um die gewünschte Injektion erzielen zu können, waren daher relativ hohe Schaltströme erforderlich.

Die intrinsischen Schaltelemente gemäß der Erfindung erlauben wegen ihrer geringen Abmessungen eine besonders hohe Packungsdichte. In Richtung der kristallographischen c-Achse liegt die Abmessung eines Stapels von Tunnelkontakten zwischen 30 Å und 30.000 Å, je nach der Anzahl der Tunnelkontakte, die zwischen der theoretischen Grenze von 1 und einer praktikablen Größenordnung von z.B. 1000 liegen kann. Senkrecht zu der kristallographischen c-Achse sind mit derzeitigen Methoden Abmessungen von 1000 - 10.000 Å realisierbar.

Aufgrund dieser vorteilhaften Eigenschaften lassen sich die intrinsischen Quasiteilchen-Injektionstransistoren nach der Erfindung zu hoch integrierten logischen Schaltkreisen zusammenfügen. Die Fig. 7 zeigt ein Ausführungsbeispiel hierfür. Die Verbindungsleitung zwischen dem Ausgang der ersten Stufe und dem Eingang der zweiten Stufe läßt sich um die Höhe eines Tunnelkontaktstapels versetzt führen (Fig. 7). Die vertikale Trennung zwischen den einzelnen Schaltelementen erfolgt mit bekannten Strukturierungsverfahren. Eine weitere Möglichkeit besteht darin, beide Einzelelemente in gleicher Höhe auf dem Substrat anzuordnen und zu verschalten.

Durch die dünnen Elektroden und durch die hohe Packungsdichte verkürzen sich die Schaltzeiten erheblich gegenüber den bekannten Tunnelkontakten und den bekannten Quasiteilchen-Injektionstransistoren. Die Schaltzeiten bestimmen sich nach der Relaxationsrate der Quasiteilchen:

$$\frac{1}{\tau}\propto\frac{\Delta}{h}.$$

Intrinsisch sind die Schaltzeiten damit um das Verhältnis der Energielücken verkürzt:

$$\frac{\tau_{klass}}{\tau_{HTC}}\propto\frac{\Delta_{HTC}}{\Delta_{klass}}\approx\frac{T_c^{HTC}}{T_c^{klass}}.$$

Da die Sprungtemperatur eines Hochtemperatur-Supraleiters um etwa eine Größenordnung über der eines klassischen Supraleiters liegt, ist die Schaltzeit eines intrinsischen Quasiteilchen-Injektionstransistors um ca. eine Größenordnung schneller.

**Patentansprüche**

1. Quasiteilchen-Injektionstransistor, schichtweise zusammengesetzt aus einem Injektor und mindestens einem Akzeptor, wobei der Injektor und der Akzeptor oder die Akzeptoren eine gemeinsame supraleitende Elektrode aufweisen, in der die Dichte der Quasiteilchen durch den Injektorstrom gesteuert wird,

**dadurch gekennzeichnet,**
daß jeder Injektor und jeder Akzeptor ein kristalliner Stapel von intrinsischen Tunnelkontakten in einem Hochtemperatursupraleiter ist, wobei Hochtemperatursupraleiter einkristalline Schichtstrukturen sind, bei denen der elektrische Transport in Ebenen oder Doppelebenen stattfindet und wobei je zwei benachbarte dieser Ebenen oder Doppelebenen durch eine Zwischenschicht miteinander so verbunden sind, daß zwischen je zwei benachbarten dieser Ebenen oder Doppelebenen ein intrinsischer Tunnelkontakt entsteht.

2. Quasiteilchen-Injektionstransistor nach Anspruch 1, dadurch gekennzeichnet, daß die Anzahl der intrinsischen Tunnelkontakte in dem oder den Akzeptorenstapeln höher ist als im Injektorstapel.

3. Quasiteilchen-Injektionstransistor nach einem der vorhergehenden Ansprüche, dadurch gekennzeichnet, daß die Stromdichte im Akzeptorstapel höher ist als die Stromdichte im Injektorstapel.

4. Quasiteilchen-Injektionstransistor nach einem der vorhergehenden Ansprüche, dadurch gekennzeichnet, daß der Injektorstapel und der Akzeptorstapel wegen ihrer gleichmäßigen intrinsischen Kopplung gleichzeitig in einen anderen Zustand schalten, so daß ein Stapel wie eine einzige Tunneldiode mit erhöhtem Spannungsabfall wirkt.

5. Quasiteilchen-Injektionstransistor nach einem der vorhergehenden Ansprüche, dadurch gekennzeichnet, daß die Strom-Spannungs-Kennlinie des Injektorstapels oder des Akzeptorstapels eine ausgeprägte Hysterese aufweist.

6. Quasiteilchen-Injektionstransistor nach einem der vorhergehenden Ansprüche, dadurch gekennzeichnet, daß die Anzahl der intrinsischen Tunnelkontakte im Akzeptor so hoch ist, daß der Spannungsabfall im resistiven Zustand bis zu 10V beträgt.

7. Quasiteilchen-Injektionstransistor nach einem der vorhergehenden Ansprüche, gekennzeichnet durch eine Doppelstapelanordnung von Akzeptoren, bei der zwei Akzeptorstapel an die gleiche Grenzfläche des Injektorstapels angrenzen.

8. Quasiteilchen-Injektionstransistor nach einem der vorhergehenden Ansprüche, dadurch gekennzeichnet, daß die supraleitenden Schichten des Hochtemperatursupraleiters durch Kupferoxid gebildet werden.

9. Quasiteilchen-Injektionstransistor nach einem der vorhergehenden Ansprüche, dadurch gekennzeichnet, daß ein Injektorstapel oder ein Akzeptorstapel ungefähr zwischen 10 nm und 10 $\mu$m dick ist.

10. Quasiteilchen-Injektionstransistor nach einem der vorhergehenden Ansprüche, dadurch gekennzeichnet, daß eine Transistorzelle in Schichtrichtung senkrecht zur kristallographischen c-Achse Abmessungen von 100 - 1000 nm aufweist.

11. Quasiteilchen-Injektionstransistor nach einem der vorhergehenden Ansprüche, gekennzeichnet durch mehr als drei elektrische Anschlüsse.

12. Quasiteilchen-Injektionstransistor nach einem der vorhergehenden Ansprüche, dadurch gekennzeichnet, daß die Anschlüsse an Grenzflächen parallel zu den supraleitfähigen Schichten der Hochtemperatursupraleiter durch Goldschichten gebildet werden.

13. Quasiteilchen-Injektionstransistor nach Anspruch 12, gekennzeichnet durch Anschlußflächenwiderstände von weniger als $10^{-4}$ Ohm cm$^2$.

14. Quasiteilchen-Injektionstransistor nach Anspruch 8, dadurch gekennzeichnet, daß der Hochtemperatur-Supraleiter aus der Klasse

$$(Bi_{1-x}Pb_x)_2Sr_2CaCu_2O_8 \qquad O \le x < 0,4$$

$$(Bi_{1-x}Pb_x)_2Sr_2Ca_2Cu_3O_{10} \qquad O \le x < 0,4$$

$$Tl_2Ba_2CaCu_2O_8$$

$$Tl_2Ba_2Ca_2Cu_3O_{10}$$

$$TlCaBa_2Cu_2O_7$$

$$TlCaBa_2Cu_3O_9$$

ausgewählt ist.

15. Quasiteilchen-Injektionstransistor nach Anspruch 14, dadurch gekennzeichnet, daß der Hochtemperatur-Supraleiter aus $Bi_2Sr_2CaCu_2O_8$ besteht.

16. Quasiteilchen-Injektionstransistor nach Anspruch 8, dadurch gekennzeichnet, daß der Hochtemperatur-Supraleiter aus $TlBa_2CuO_5$ oder aus einer anderen Keramik der Klasse mit einfachen $CuO_2$-Ebenen besteht.

**17.** Verfahren zur Herstellung eines Quasiteilchen-Injektionstransistors mit einem Injektor und mindestens einem Akzeptor, die gemäß Anspruch 1 jeweils aus einem kristallinen Stapel von intrinsischen Tunnelkontakten in einem Hochtemperatur-Supraleiter bestehen und eine gemeinsame supraleitende Elektrode aufweisen,
umfassend die folgenden Herstellungsschritte zur Bildung mindestens eines intrinsischen Quasiteilchen-Injektionstransistors:

- zwei oder mehr einkristalline Stapel von intrinsischen Tunnelkontakten werden durch Ziehen oder epitaktisches Aufbringen eines Einkristalls oder durch Strukturieren einer epitaktisch auf einem Substrat aufgebrachten Schicht erzeugt, so daß sie mindestens eine Grenzfläche parallel zu supraleitfähigen Ebenen oder Doppelebenen des Hochtemperatursupraleiters gemeinsamen haben;

- die einkristallinen Stapel werden zur Beeinflussung der elektrischen Leitfähigkeit der Gebiete zwischen den supraleitenden Ebenen oder Doppelebenen der einkristallinen Stapel, in inerter Atmosphäre oder im Vakuum, bei kontrolliertem Sauerstoff-Partialdruck hergestellt oder nachbehandelt;

- an der gemeinsamen Grenzfläche und an den weiteren Grenzflächen, die parallel zu den supraleitfähigen Schichten der einkristallinen Stapel liegen, werden drei oder mehr gut leitfähige Kontakte aufgebracht.

**18.** Verfahren nach Anspruch 17, dadurch gekennzeichnet, daß der Hochtemperatur-Supraleiter aus der Klasse

$$(Bi_{1-x}Pb_x)_2Sr_2CaCu_2O_8 \qquad O \leq x < 0,4$$

$$(Bi_{1-x}Pb_x)_2Sr_2Ca_2Cu_3O_{10} \qquad O \leq x < 0,4$$

$$Tl_2Ba_2CaCu_2O_8$$

$$Tl_2Ba_2Ca_2Cu_3O_{10}$$

$$TlCaBa_2Cu_2O_7$$

$$TlCaBa_2Cu_3O_9$$

ausgewählt ist.

**19.** Verfahren nach Anspruch 18, dadurch gekennzeichnet, daß der Hochtemperatur-Supraleiter aus $Bi_2Sr_2CaCu_2O_8$ besteht.

**20.** Verfahren nach Anspruch 17, dadurch gekennzeichnet, daß der Hochtemperatur-Supraleiter aus $TlBa_2CuO_5$-Ebenen besteht.

**21.** Verfahren nach einem der Ansprüche 17 bis 20, gekennzeichnet durch Argon, Helium oder Stickstoff als Inertgas.

**22.** Verfahren nach einem der Ansprüche 17 bis 21, dadurch gekennzeichnet, daß der kontrollierte Sauerstoff-Partialdruck zwischen null und mehreren 100 bar liegt.

**23.** Verfahren nach einem der Ansprüche 17 bis 22, gekennzeichnet durch Tempern in Argon-Atmosphäre als Nachbehandlung.

**24.** Verfahren nach Anspruch 23, gekennzeichnet durch Tempern bei etwa 700°C oder geringeren Temperaturen.

**25.** Verfahren nach einem der Ansprüche 17 bis 24, dadurch gekennzeichnet, daß gut leitfähige Kontakte aus Gold aufgebracht werden.

**26.** Verfahren nach einem der Ansprüche 17 bis 25, gekennzeichnet durch Interkalation von Jod, Brom oder anderen großen Atomen in das Gefüge des Hochtemperatur-Supraleiters.

**27.** Verfahren nach Anspruch 18, dadurch gekennzeichnet, daß zur Beeinflussung der Leitfähigkeit zwischen den supraleitenden Schichten in Tl-Systemen die Ca-Zugabe eingestellt wird.

**28.** Verwendung des Quasiteilchen-Injektionstransistors nach einem der Ansprüche 1 bis 16, mit weiteren Injektionstransistoren dieser Bauart in einem hochintegrierten logischen Schaltkreis.

**29.** Verwendung nach Anspruch 28, bei der die Verbindungsleitung zwischen dem Ausgang einer ersten Schaltstufe und dem Eingang der folgenden Schaltstufe um die Höhe eines Tunnelkontaktstapels versetzt geführt ist.

**30.** Verwendung nach Anspruch 29, bei der der zweite Quasiteilchen-Injektionstransistor in Richtung der kristallographischen c-Achse über dem ersten Quasiteilchen-Injektionstransistor angeordnet und verschaltet ist.

**31.** Verwendung nach Anspruch 28 oder 29, bei der der zweite Quasiteilchen-Injektionstransistor in gleicher Höhe wie der erste Quasiteilchen-Injektionstransistor auf einem Substrat angeordnet und verschaltet ist.

## Claims

1.  Quasi-particle injection transistor, composed in layers of an injector and at least one acceptor where the injector and the acceptor or the acceptors comprise a common superconducting electrode, in which the density of the quasi-particles is controlled by the injector current, **characterized in that** each injector and each acceptor consists of a crystalline pile of intrinsic tunnel junctions in a high-temperature superconductor, where the high-temperature superconductor is a single-crystal layer structure, where the electrical transport takes place in layers or double layers and where each two adjacent layers or double layers are connected to each other by an intermediate layer so that between each two adjacent layers or double layers an intrinsic tunnel junction is created.

2.  Quasi-particle injection transistor according to claim 1, characterized in that the number of intrinsic tunnel junctions in the acceptor pile or the acceptor piles is greater than in the injector pile.

3.  Quasi-particle injection transistor according to one of the previous claims, characterized in that the current density in the acceptor pile is higher than the current density in the injector pile.

4.  Quasi-particle injection transistor according to one of the previous claims, characterized in that the injector pile and the acceptor pile are switched simultaneously to a different state, because of their homogenous intrinsic coupling so that a pile acts as a single tunnel diode having increased voltage potential.

5.  Quasi-particle injection transistor according to one of the previous claims, characterized in that the current-voltage-characteristic of an injector pile or an acceptor pile has a pronounced hysteresis.

6.  Quasi-particle injection transistor according to one of the previous claims, characterized in that the number of intrinsic tunnel junctions in the acceptor is as great as causing a voltage potential in a resistive state of up to 10 V.

7.  Quasi-particle injection transistor according to one of the previous claims, characterized by a double pile arrangement of acceptors, wherein the two acceptor piles adjoin a boundary surface of the injector pile.

8.  Quasi-particle injection transistor according to one of the previous claims, characterized in that the superconducting layers of the high-temperature superconductor are formed by copper oxide.

9.  Quasi-particle injection transistor according to one of the previous claims, characterized in that an injector pile or acceptor pile have a thickness of about 10 nm to 10 mμ.

10. Quasi-particle injection transistor according to one of the previous claims, characterized in that a transistor cell has dimensions of 100 to 1000 nm in the direction of the layer, that is perpendicular to the crystallographic c-axis.

11. Quasi-particle injection transistor according to one of the previous claims, characterized by more than three electric terminals.

12. Quasi-particle injection transistor according to one of the previous claims, characterized in that the terminals are formed at boundary layers parallel to the superconducting layers of the high-temperature superconductors by gold layers.

13. Quasi-particle injection transistor according to claim 12, characterized in that the terminal surface resistance is less than $10^{-4}$ Ohm cm$^2$.

14. Quasi-particle injection transistor according to claim 8, characterized in that the high-temperature superconductor is selected from the class:

$$(Bi_{1-x}Pb_x)_2Sr_2CaCu_2O_8 \qquad O \le x < 0,4$$

$$(Bi_{1-x}Pb_x)_2Sr_2Ca_2Cu_3O_{10} \qquad O \le x < 0,4$$

$$Tl_2Ba_2CaCu_2O_8$$

$$Tl_2Ba_2Ca_2Cu_3O_{10}$$

$$TlCaBa_2Cu_2O_7$$

$$TlCaBa_2Cu_3O_9$$

15. Quasi-particle injection transistor according to claim 14, characterized in that the high-temperature superconductor consists of $Bi_2Sr_2CaCu_2O_8$.

16. Quasi-particle injection transistor according to claim 8, characterized in that the high-temperature

superconductor consists of $TlBa_2CuO_5$ or of another ceramic of the class having single $CuO_2$-layers.

17. A method for manufacturing a quasi-particle injection transistor with one injector and at least one acceptor which consists according to claim 1 each of a crystalline pile of intrinsic tunnel junctions in a high-temperature superconductor and which comprise a common superconducting electrode, comprising the following manufacturing steps for forming at least one intrinsic quasi-particle injection transistor:

- Two or more single-crystal piles of intrinsic tunnel junctions are generated either by drawing or epitaxially depositing of a single crystal or by structuring a layer, which is epitaxially deposited on a substrate such that they have at least one boundary surface in common parallel to the superconducting layers or double layers of the high-temperature superconductor;

- the single crystal piles are fabricated or post-processed in an inert atmosphere or in a vacuum at controlled oxygen partial pressure for affecting the electrical conductivity of the regions between the superconducting layers or double layers of the single-crystal piles;

- three or more well conducting terminals are deposited at the common boundary surface and at the further boundary surfaces parallel to the superconducting layers of the single-crystalline piles.

18. Method according to claim 17 characterized, in that the high-temperature superconductor is selected from the class

$$(Bi_{1-x}Pb_x)_2Sr_2CaCu_2O_8 \qquad O \leq x < 0,4$$

$$(Bi_{1-x}Pb_x)_2Sr_2Ca_2Cu_3O_{10} \qquad O \leq x < 0,4$$

$$Tl_2Ba_2CaCu_2O_8$$

$$Tl_2Ba_2Ca_2Cu_3O_{10}$$

$$TlCaBa_2Cu_2O_7$$

$$TlCaBa_2Cu_3O_9.$$

19. Method according to claim 18, characterized in that the high-temperature superconductor consists of $Bi_2Sr_2CaCu_2O_8$.

20. Method according to claim 17, characterized in that the high-temperature superconductor consists of layers of $TlBa_2CuO_5$.

21. Method according to one of the claims 17 to 20, characterized by argon, helium or nitrogen as an inert gas.

22. Method according to one of the claims 17 to 21, characterized in that the controlled oxygen partial pressure is between 0 and several hundred bars.

23. Method according to one of the claims 17 to 22, charaterized by tempering on an argon atmosphere for post-processing.

24. Method according to claims 23, characterized by tempering at about 700°C or lower temperatures.

25. Method according to one of the claims 17 to 24, characterized in that well conducting contacts of gold are deposited.

26. Method according to one of the claims 17 to 25, characterized by the intercalation of iodine, bromine or other large atoms into the structure of the high-temperature superconductor.

27. Method according to claim 18, characterized in that the addition of Ca is adjusted for effecting the conductivity between the superconducting layers and T1-systems.

28. Use of a quasi-particle injection transistor according to one of the claims 1 to 16 together with other injection transistors of this kind in large scale integrated logic circuit.

29. Use according to claim 28, whereby the inter connection line between the output of a first circuit stage and the input of a subsequent circuit stage is offset by the height of a tunnel junction pile.

30. Use according to claim 29, whereby the second quasi-particle injection transistor is arranged and connected on top of the first quasi-particle injection transistor in the direction of the crystallographic c-axis.

31. Use according to claim 28 or 29, wherein the second quasi-particle injection transistor is arranged and connected on a substrate at the same height as the first quasi-particle injection transistor.

## Revendications

1. Transistor à injection de quasi-particules, constitué d'un injecteur et d'au moins un accepteur sous la forme de couches, où l'injecteur et le ou les accepteurs présentent une électrode commune supraconductrice, dans laquelle la densité des quasi-particules est commandée par le courant de l'injecteur, caractérisé en ce que,
chaque injecteur et chaque accepteur sont un empilement cristallin de contacts intrinsèques à effet tunnel dans un supraconducteur haute température, les supraconducteurs haute température étant des structures à couches monocristallines, dans lesquelles le transport électrique s'effectue dans des plans ou doubles plans et deux de ces plans voisins ou doubles plans sont chaque fois reliés l'un à l'autre par le biais d'une couche intermédiaire, de telle sorte qu'un contact à effet tunnel intrinsèque soit généré entre chaque fois deux de ces plans voisins ou doubles plans.

2. Transistor à injection de quasi-particules suivant la revendication 1, caractérisé en ce que le nombre des contacts intrinsèques à effet tunnel est plus grand dans le ou les empilements d'accepteur que dans l'empilement d'injecteur.

3. Transistor à injection de quasi-particules suivant l'une quelconque des revendications précédentes, caractérisé en ce que la densité de courant dans l'empilement d'accepteur est supérieure à la densité de courant dans l'empilement d'injecteur.

4. Transistor à injection de quasi-particules suivant l'une quelconque des revendications précédentes, caractérisé en ce que l'empilement d'injecteur et l'empilement d'accepteur commutent simultanément vers un autre état en raison de leur couplage intrinsèque uniforme, de sorte qu'un empilement agit comme une unique diode à effet tunnel à chute de tension accrue.

5. Transistor à injection de quasi-particules suivant l'une quelconque des revendications précédentes, caractérisé en ce que la courbe caractéristique courant-tension de l'empilement d'injecteur ou de l'empilement d'accepteur présente une hystérésis plus marquée.

6. Transistor à injection de quasi-particules suivant l'une quelconque des revendications précédentes, caractérisé en ce que le nombre de contacts intrinsèques à effet tunnel est tellement élevé dans l'accepteur que la chute de tension en état résistif atteint jusqu'à 10V.

7. Transistor à injection de quasi-particules suivant l'une quelconque des revendications précédentes, caractérisé par un agencement sous la forme d'un double empilement d'accepteurs, dans lequel deux empilements d'accepteur sont adjacents à la même surface limitrophe de l'empilement d'injecteur.

8. Transistor à injection de quasi-particules suivant l'une quelconque des revendications précédentes, caractérisé en ce que les couches supraconductrices du supraconducteur haute température sont composées d'oxyde de cuivre.

9. Transistor à injection de quasi-particules suivant l'une quelconque des revendications précédentes, caractérisé en ce qu'un empilement d'injecteur ou un empilement d'accepteur présente une épaisseur comprise entre environ 10 nm et 10 microns.

10. Transistor à injection de quasi-particules suivant l'une quelconque des revendications précédentes, caractérisé en ce qu'une cellule de transistor présente des dimensions de 100 à 1000 nm, dans le sens de la couche, à la verticale de l'axe c cristallographique.

11. Transistor à injection de quasi-particules suivant l'une quelconque des revendications précédentes, caractérisé par plus de trois connexions électriques.

12. Transistor à injection de quasi-particules suivant l'une quelconque des revendications précédentes, caractérisé en ce que les connexions aux surfaces limitrophes sont formées en parallèle par rapport aux couches supraconductrices du supraconducteur haute température au moyen de couches d'or.

13. Transistor à injection de quasi-particules suivant la revendication 12, caractérisé par des résistances des surfaces de connexion inférieures à $10^{-4}$ Ohm $cm^2$.

14. Transistor à injection de quasi-particules suivant la revendication 8, caractérisé en ce que le supraconducteur haute température est sélectionné dans le groupe des

$$(Bi_{1-x}Pb_x)_2Sr_2CaCu_2O_8 \qquad O \leq x < 0,4$$

$$(Bi_{1-x}Pb_x)_2Sr_2Ca_2Cu_3O_{10} \qquad O \leq x < 0,4$$

$$Tl_2Ba_2CaCu_2O_8$$

$$Tl_2Ba_2Ca_2Cu_3O_{10}$$

$$TlCaBa_2Cu_2O_7$$

$$TlCaBa_2Cu_3O_9$$

**15.** Transistor à injection de quasi-particules suivant la revendication 14, caractérisé en ce que le supraconducteur haute température est fait de $Bi_2Sr_2CaCu_2O_8$.

**16.** Transistor à injection de quasi-particules suivant la revendication 8, caractérisé en ce que le supraconducteur haute température est fait de $TlBa_2CuO_5$ ou d'une autre céramique du groupe composé de plans simples en $CuO_2$.

**17.** Procédé de fabrication d'un transistor à injection de quasi-particules doté d'un injecteur et d'au moins un accepteur, qui, conformément à la revendication 1, sont composés respectivement d'un empilement cristallin de contacts intrinsèques à effet tunnel dans un supraconducteur haute température et d'une électrode commune supraconductrice, comprenant les étapes de fabrication suivantes pour former au moins un transistor à injection de quasi-particules intrinsèques:

- deux ou plus de deux empilements monocristallins de contacts intrinsèques à effet tunnel sont formés par tirage ou par croissance épitaxiale d'un monocristal ou par structuration d'une couche formée par épitaxie sur un substrat de telle sorte qu'ils possèdent au moins en commun une surface limitrophe parallèle aux plans supraconducteurs ou aux doubles plans du supraconducteur haute température;
- les empilements monocristallins sont construits ou traités ultérieurement afin d'influencer la conductivité électrique des régions entre les plans supraconducteurs ou doubles plans des empilements monocristallins, en atmosphère inerte ou sous vide, sous pression partielle en oxygène contrôlée;
- trois ou plus de trois contacts présentant de bonnes propriétés de conduction sont appliqués sur la surface limitrophe commune et les autres surfaces limitrophes, qui sont parallèles aux couches supraconductrices des empilements monocristallins.

**18.** Procédé suivant la revendication 17, caractérisé en ce que le supraconducteur haute température est sélectionné dans le groupe des

$$(Bi_{1-x}Pb_x)_2Sr_2CaCu_2O_8 \qquad O \leq x < 0,4$$

$$(Bi_{1-x}Pb_x)_2Sr_2Ca_2Cu_3O_{10} \qquad O \leq x < 0,4$$

$$Tl_2Ba_2CaCu_2O_8$$

$$Tl_2Ba_2Ca_2Cu_3O_{10}$$

$$TlCaBa_2Cu_2O_7$$

$$TlCaBa_2Cu_3O_9$$

**19.** Procédé suivant la revendication 18, caractérisé en ce que le supraconducteur haute température est fait de $Bi_2Sr_2CaCu_2O_8$.

**20.** Procédé suivant la revendication 17, caractérisé en ce que le supraconducteur haute température est fait de plans en $TlBa_2CuO_5$.

**21.** Procédé suivant l'une quelconque des revendications 17 à 20, caractérisé en ce que l'argon, l'hélium ou l'azote sert de gaz inerte.

**22.** Procédé suivant l'une quelconque des revendications 17 à 21, caractérisé en ce que la pression partielle en oxygène contrôlée se situe entre zéro et plusieurs centaines de bars.

**23.** Procédé suivant l'une quelconque des revendications 17 à 22, caractérisé par un recuit en atmosphère d'argon comme traitement ultérieur.

**24.** Procédé suivant la revendication 23, caractérisé par un recuit à une température d'environ 700°C ou à des températures plus basses.

**25.** Procédé suivant l'une quelconque des revendications 17 à 24, caractérisé en ce que des contacts en or présentant de bonnes propriétés de conduction sont déposés.

**26.** Procédé suivant l'une quelconque des revendications 17 à 25, caractérisé par l'intercalation d'iode, de brome ou d'autres gros atomes dans la texture du supraconducteur haute température.

**27.** Procédé suivant la revendication 18, caractérisé en ce que, pour influencer la conductivité entre les couches supraconductrices dans les systèmes au Tl, on ajuste l'apport en Ca.

**28.** Mise en oeuvre du transistor à injection de quasi-particules suivant l'une quelconque des revendications 1 à 16, avec d'autres transistors à injection de ce type de construction dans un circuit logique à haute intégration.

29. Mise en oeuvre suivant la revendication 28, dans laquelle le câble de connexion reliant la sortie d'un premier plot d'un premier étage de commutation et l'entrée du plot de l'étage de commutation suivant est guidé avec un décalage de la hauteur d'un empilement de contact à effet tunnel.

30. Mise en oeuvre suivant la revendication 29, dans laquelle le deuxième transistor à injection de quasi-particules est agencé et connecté, dans la direction de l'axe c cristallographique, au-dessus du premier transistor à injection de quasi-particules.

31. Mise en oeuvre suivant la revendication 28 ou 29, dans laquelle le deuxième transistor à injection de quasi-particules est agencé et connecté sur un substrat à la même hauteur que le premier transistor à injection de quasi-particules.

Fig. 1

Fig. 2 (a)

Fig. 2 (b)

Fig. 3 (a)

CuO - Ebene bzw. Doppelebene
(ca. 0.3 nm)

isolierende Zwischenschicht
(ca. 0.8 - 2 nm)

J

Fig. 3 (b)

Akzeptorstrom

Isolierende
Zwischenschicht

Akzeptor-
Tunnelkontakt

Lastwiderstand

Injektor-
Tunnelkontakt

CuO-Ebene bzw.
Doppelebene

Injektorstrom

Fig. 4

Akzeptorstrom

Akzeptor-
Stapel

Lastwiderstand

Injektor-
Stapel

Injektorstrom

Fig. 5 (a)

Akzeptorstrom

Akzeptor-
Stapel

Lastwiderstand

Injektor-
Stapel

Injektorstrom

Fig. 5 (b)

Lastwiderstand

Akzeptorstrom

Injektorstrom

Fig. 6

Lastwiderstand

Akzeptorstrom

Akzeptorstrom

Injektorstrom

Fig. 7